# EUROPEAN PATENT APPLICATION

(11) **EP 4 753 427 A1**
(43) Date of publication of application: **03.06.2026**
(21) Application number: 25205756.7
(22) Date of filing: 30.09.2025
(51) Int. Cl.: H10K 59/35, H10K 50/15, H10K 50/16

(54) **ELECTROLUMINESCENT DISPLAY DEVICE**

(30) Priority: 28.11.2024 KR 20240173129
(71) Applicant: LG Display Co., Ltd., Seoul, 07336 (KR)
(72) Inventor: PARK, JinHo, 10845 Gyeonggi-do (KR)
(74) Representative: Viering, Jentschura & Partner mbB Patent- und Rechtsanwälte

(57) **Abstract**

An electroluminescent display device can include a substrate (100) including a first sub-pixel (R Sub-pixel) and a second sub-pixel (G Sub-pixel), a first electrode (400) in each of the first sub-pixel (R Sub-pixel) and the second sub-pixel (G Sub-pixel) on the substrate (100), a light emitting part (500) on the first electrode (400), and a second electrode (600) on the light emitting part (500). The light emitting part (500) includes a hole transport layer (HTL1, HTL2-2(R)), HTL2-1(G)), a first light emitting layer (EML(R)) disposed in the first sub-pixel (R Sub-pixel), a second light emitting layer (EML(G)) disposed in the second sub-pixel (G Sub-pixel), and an electron transport layer (ETL). The second light emitting layer (EML(G)) extends to the first sub-pixel (R Sub-pixel) and is disposed under the first light emitting layer (EML(R)). The hole transport layer (HTL1, HTL2-2(R)), HTL2-1(G)) is disposed between the second light emitting layer (EML(G)) and the first light emitting layer (EML(R)) in the first sub-pixel (R Sub-pixel).

## Description

### BACKGROUND

### Field of Technology

The present disclosure relates to an electroluminescent display device.

### Description of the Related Art

An electroluminescent display device includes a first electrode, a second electrode, and a light emitting layer disposed between the first electrode and the second electrode, and displays an image by emitting the light emitting layer by an electric field between the first electrode and the second electrode.

The electroluminescent display device includes a red sub-pixel, a green sub-pixel, and a blue sub-pixel, and a light emitting layer disposed in each of the sub-pixels.

The light emitting layer is formed in each of sub-pixels by a deposition process using a mask.

However, due to a limitation of the deposition process, the light emitting layer can be deposited not only in the corresponding sub-pixel, but also in other sub-pixels adjacent to the corresponding sub-pixel. Accordingly, there can be a limitation in that a color of light emitted from the other sub-pixels can be changed.

In particular, a color change of a light emitted from a side viewing angle can be greater than a color change of a light emitted from a front viewing angle.

### SUMMARY OF THE DISCLOSURE

The present disclosure has been made to address or overcome the above problems and other limitations associated with the related art.

As such, it is an aspect of the present disclosure to provide an electroluminescent display device that can solve or address a problem of a color change of a light emitted from both front and side viewing angles, even when a light emitting layer is deposited not only in the corresponding sub-pixel, but also in other sub-pixels adjacent to the corresponding sub-pixel. According to an aspect of the present disclosure, an electroluminescent display device according to claim 1 is provided. Further embodiments are described in the dependent claims.

In accordance with an aspect of the present disclosure, the above and other technical effects can be accomplished by the provision of an electroluminescent display device comprising a substrate including a first sub-pixel and a second sub-pixel, a first electrode in each of the first sub-pixel and the second sub-pixel on the substrate, a light emitting part on the first electrode, and a second electrode on the light emitting part, wherein the light emitting part includes a hole transport layer, a first light emitting layer disposed in the first sub-pixel, a second light emitting layer disposed in the second sub-pixel, and an electron transport layer, wherein the second light emitting layer extends to the first sub-pixel and is disposed under the first light emitting layer, and wherein the hole transport layer is disposed between the second light emitting layer and the first light emitting layer in the first sub-pixel.

In addition, in accordance with an aspect of the present disclosure, the above and other technical effects can be accomplished by the provision of an electroluminescent display device comprising a red sub-pixel including a red light emitting layer, a green sub-pixel including a green light emitting layer, a blue sub-pixel including a blue light emitting layer, a first hole transport layer which is disposed in the red sub-pixel, the green sub-pixel and the blue sub-pixel, and is disposed under the red light emitting layer, the green light emitting layer, and the blue light emitting layer, a 2-1th hole transport layer disposed between the first hole transport layer and the green light emitting layer, and a 2-2th hole transport layer disposed between the first hole transport layer and the red light emitting layer, wherein the green light emitting layer extends to the red sub-pixel and is disposed under the red light emitting layer, and wherein the 2-2th hole transport layer is disposed between the green light emitting layer and the red light emitting layer.

In addition, in accordance with an aspect of the present disclosure, the above and other technical effects can be accomplished by the provision of an electroluminescent display device comprising a red sub-pixel including a red light emitting layer, a green sub-pixel including a green light emitting layer, a blue sub-pixel including a blue light emitting layer, a first hole transport layer which is disposed in the red sub-pixel, the green sub-pixel and the blue sub-pixel, and is disposed under the red light emitting layer, the green light emitting layer, and the blue light emitting layer, a 2-1th hole transport layer disposed between the first hole transport layer and the green light emitting layer, and a 2-2th hole transport layer disposed between the first hole transport layer and the red light emitting layer, wherein the blue light emitting layer extends to the green sub-pixel and is disposed under the green light emitting layer, and wherein the 2-1th hole transport layer is disposed between the green light emitting layer and the blue light emitting layer.

It is to be understood that both the foregoing general description and the following detailed description are exemplary and explanatory and are intended to provide further explanation of the inventive concepts as claimed

### BRIEF DESCRIPTION OF THE DRAWINGS

The accompanying drawings, which are included to provide a further understanding of the disclosure and are incorporated in and constitute a part of this application, illustrate embodiments of the disclosure and together with the description explain the principle of the disclosure. In the drawings:
FIGS. 1A and 1B show a spectrum according to a wavelength band of a light emitting layer, and are graphs showing changes in an EL (electroluminescence) spectrum according to a viewing angle in a red wavelength band of a red light emitting layer. For instance, FIG. 1A is an EL spectrum of a red light emitting layer at a front viewing angle, and FIG. 1B is an EL spectrum of a red light emitting layer at a side viewing angle.
FIGS. 2A and 2B show a spectrum according to a wavelength band of a light emitting layer, and are graphs showing changes in an EL (electroluminescence) spectrum according to a viewing angle in a green wavelength band of a green light emitting layer. For instance, FIG. 2A is an EL spectrum of a green light emitting layer at a front viewing angle, and FIG. 2B is an EL spectrum of a green light emitting layer at a side viewing angle.
FIGS. 3A and 3B show a spectrum according to a wavelength band of a light emitting layer, and are graphs showing changes in an EL (electroluminescence) spectrum according to a viewing angle in a blue wavelength band of a blue light emitting layer. For instance, FIG. 3A is an EL spectrum of a blue light emitting layer at a front viewing angle, and FIG. 3B is an EL spectrum of a blue light emitting layer at a side viewing angle.
FIG. 4 is a plan view showing a pixel structure of an electroluminescent display device according to an embodiment of the present disclosure.
FIG. 5 is a schematic cross-sectional view of an electroluminescent display device according to an embodiment of the present disclosure, which shows a red sub-pixel and a green sub-pixel adjacent to each other.
FIG. 6 is an energy band diagram of a light emitting part of a red sub-pixel of an electroluminescent display device according to an embodiment of the present disclosure.
FIG. 7 is a schematic cross-sectional view of an electroluminescent display device according to another embodiment of the present disclosure, which shows a red sub-pixel and a green sub-pixel adjacent to each other.
FIG. 8 is a schematic cross-sectional view of an electroluminescent display device according to an embodiment of the present disclosure, which shows a green sub-pixel and a blue sub-pixel adjacent to each other.
FIG. 9 is a schematic cross-sectional view of an electroluminescent display device according to another embodiment of the present disclosure, which shows a green sub-pixel and a blue sub-pixel adjacent to each other.
FIG. 10 is a schematic cross-sectional view of an electroluminescent display device according to an embodiment of the present disclosure, which shows a red sub-pixel and a blue sub-pixel adjacent to each other.
FIG. 11 is a schematic cross-sectional view of an electroluminescent display device according to another embodiment of the present disclosure, which shows a red sub-pixel and a blue sub-pixel adjacent to each other.
FIG. 12A is an EL spectrum of a red sub-pixel according to a comparative example, and FIG. 12B is an EL spectrum of a red sub-pixel according to an embodiment of the present disclosure.

Throughout the drawings and the detailed description, unless otherwise described, the same drawing reference numerals should be understood to refer to the same elements, features, and structures. The relative size and depiction of these elements can be exaggerated for clarity, illustration, and convenience.

### DETAILED DESCRIPTION OF THE EMBODIMENTS

Reference will now be made in detail to embodiments of the present disclosure, examples of which can be illustrated in the accompanying drawings. The progression of processing steps and/or operations described is an example; however, the sequence of steps and/or operations is not limited to that set forth herein and can be changed as is known in the art, with the exception of steps and/or operations necessarily occurring in a particular order. Names of the respective elements used in the following explanations can be selected only for convenience of writing the specification and can be thus different from those used in actual products.

Advantages and features of the present disclosure and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete and will fully convey the scope of the present disclosure to those skilled in the art. Further, the present disclosure is only defined by scopes of claims.

A shape, a size, a ratio, an angle and a number disclosed in the drawings for describing embodiments of the present disclosure are merely an example and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have' and 'include' described in the present disclosure are used, another portion can be added unless 'only' is used. The terms of a singular form can include plural forms unless referred to the contrary.

In interpreting the components, it is interpreted as including the error range even if there is no separate explicit description of the error range.

In describing a position relationship, for example, when the position relationship is described as 'upon', 'above', 'below' and 'next to', one or more portions can be disposed between two other portions unless 'just' or 'direct' is used. The terms, such as "below," "lower," "above," "upper" and the like, can be used herein to describe a relationship between element (s) as illustrated in the drawings. It will be understood that the terms are spatially relative and based on the orientation depicted in the drawings.

A description of a time relationship can include a case in which the temporal precedence relationship is described as "after", "following", or "before", etc., and is not continuous unless "right away" or "directly", is used.

Although the terms such as first, second, and the like are used to describe various components, these components are not limited by these terms. These terms are used only to distinguish one component from another and may not define order or sequence. Therefore, a first component mentioned below can be a second component within a technical idea of a present disclosure.

It will be understood that, although the terms such as "first," "second," "A," "B," "(a)," and "(b)" etc. can be used herein to describe various elements, these elements should not be limited by these terms. These terms are only used to distinguish one element from another. For example, a first element could be termed a second element, and, similarly, a second element could be termed a first element, without departing from the scope of the present disclosure.

If a component is stated to be "connected," "coupled," "linked," or "attached" to another component, that component can be connected, coupled, linked, or attached directly to that other component, but it should be understood that other components can be interposed between each component that can be connected, coupled, linked, or attached indirectly, without any specific description.

It should be understood that if a component or layer is stated to be "overlapping" with another component or layer, the component or layer can be in direct contact or overlapping with another component or layer, but other components can be interposed between each component that can be indirectly overlapping without particular explicit description.

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

Terms such as "first direction", "second direction", "third direction", "X-axis direction", "Y-axis direction", and "Z-axis direction" should not be interpreted only as a geometric relationship perpendicular to each other, but can mean that the configuration of the present disclosure has a wider directivity within a range in which the configuration of the present disclosure can functionally act. Further, the term "can" fully encompasses all the meanings and coverages of the term "may" and vice versa.

Features of each of the various embodiments of the present specification can be partially or entirely coupled or combined with each other, technically various interworking and driving are possible, and each of the embodiments can be independently implemented with respect to each other or can be implemented together in a related relationship.

Hereinafter, various embodiments of the present disclosure will be described in detail with reference to the accompanying drawings. All the components of each display device/apparatus according to all embodiments of the present disclosure are operatively coupled and configured.

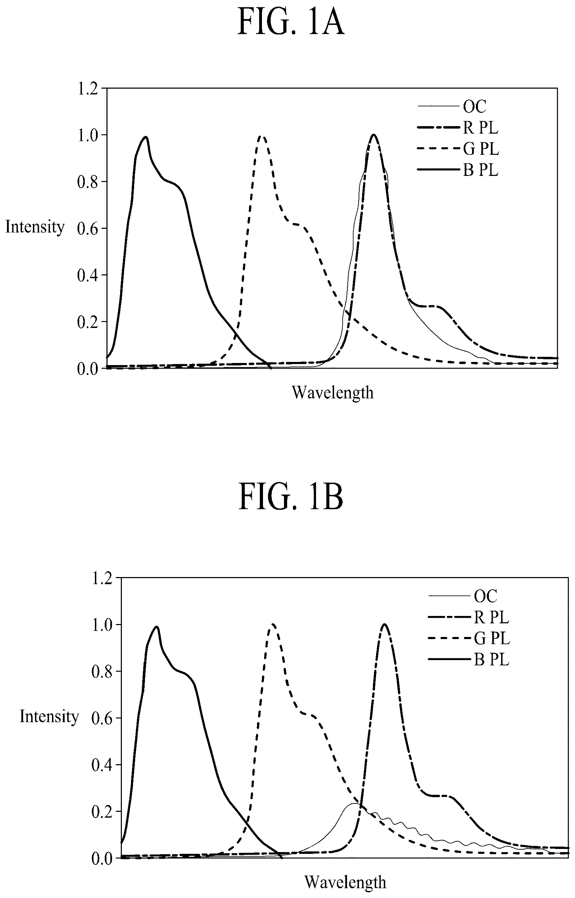

FIGS. 1A and 1B show a spectrum according to a wavelength band of a light emitting layer, and are graphs showing changes in an EL (electroluminescence) spectrum according to a viewing angle in a red wavelength band of a red light emitting layer. For instance, FIG. 1A is an EL spectrum at a front viewing angle, and FIG. 1B is an EL spectrum at a side viewing angle. In the present disclosure, the side viewing angle is a viewing angle at 60 degrees.

As can be seen from FIGS. 1A and 1B, a PL (Photoluminescence) spectrum in a blue wavelength band of the blue (B) light emitting layer and a PL spectrum in a green wavelength band of the green (G) light emitting layer overlap each other in some wavelength bands, the PL spectrum in the green wavelength band of the green (G) light emitting layer and a PL spectrum in a red wavelength band of a red (R) light emitting layer overlap each other in some wavelength bands, and the PL spectrum in the blue wavelength band of the blue (B) light emitting layer and the PL spectrum in the red wavelength band of the red (R) light emitting layer may not overlap.

A product of the PL spectrum in the red wavelength band of the red (R) light emitting layer and an OC (Out-coupling Curve) spectrum set in consideration of microcavity characteristics finally becomes the EL spectrum in the red wavelength band of the red (R) light emitting layer.

As shown in FIG. 1A, the OC spectrum does not change at the front viewing angle, but as shown in FIG. 1B, the OC spectrum is shifted toward a short wavelength at the side viewing angle.

In this way, when the OC spectrum in the red wavelength band is shifted toward the short wavelength, a peak wavelength of the EL spectrum in the red wavelength band is shifted toward the short wavelength, and an intensity of the peak wavelength decreases. In addition, the OC spectrum in the red wavelength band still does not overlaps the PL spectrum in the blue wavelength band of the blue (B) light emitting layer, but an overlapping area between the OC spectrum in the red wavelength band and the PL spectrum in the green wavelength band of the green (G) light emitting layer increases.

Accordingly, if the green (G) light emitting layer emits light in the red sub-pixel, there is no big problem with a color of a red light emitted at the front viewing angle, but there is a problem with a color change of the red light emitted at the side viewing angle.

As a result, from FIGS. 1A and 1B, there is no problem with the red light emitted from the red sub-pixel if the blue light emitting layer emits light in the red sub-pixel, but there is a problem with the color change of the red light emitted from the side viewing angle if the green light emitting layer emits light.

According to an embodiment of the present disclosure, even when the green light emitting layer emits light in the red sub-pixel, the color of the red light emitted from the side viewing angle does not change, which will be described later.

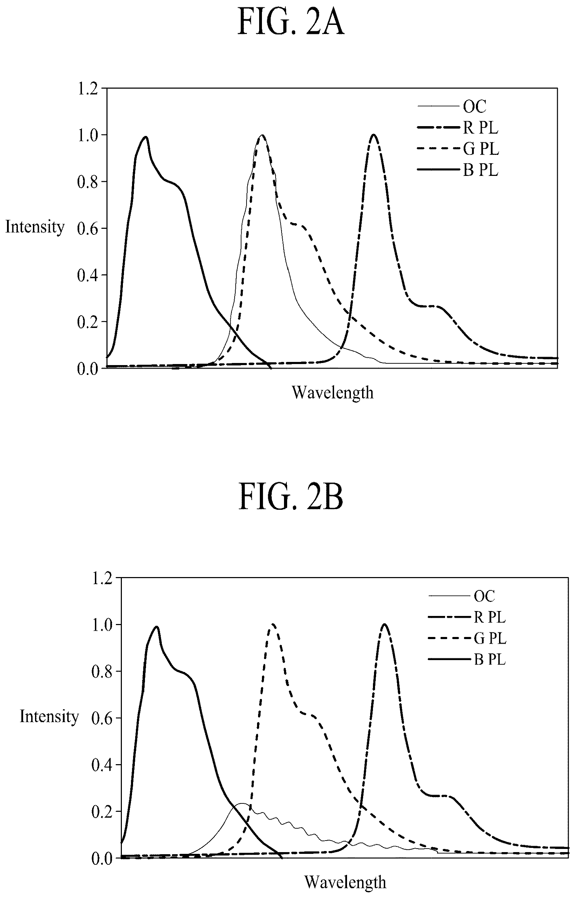

FIGS. 2A and 2B show a spectrum according to a wavelength band of a light emitting layer, and are graphs showing changes in an EL (electroluminescence) spectrum according to a viewing angle in a green wavelength band of a green light emitting layer. For instance, FIG. 2A is an EL spectrum at a front viewing angle, and FIG. 2B is an EL spectrum at a side viewing angle.

As can be seen from FIGS. 2A and 2B, a product of the PL spectrum in the green wavelength band of the green (G) light emitting layer and an OC (Out-coupling Curve) spectrum set in consideration of microcavity characteristics finally becomes the EL spectrum in the green wavelength band of the green (G) light emitting layer.

As shown in FIG. 2A, the OC spectrum does not change at the front viewing angle, but as shown in FIG. 2B, the OC spectrum is shifted toward a short wavelength at the side viewing angle.

In this way, when the OC spectrum in the green wavelength band is shifted toward the short wavelength, a peak wavelength of the EL spectrum in the green wavelength band is shifted toward the short wavelength, and an intensity of the peak wavelength decreases. In addition, an overlapping area between the OC spectrum in the green wavelength band and the PL spectrum in the red wavelength band of the red (R) light emitting layer does not increase, but an overlapping area between the OC spectrum in the green wavelength band and the PL spectrum in the blue wavelength band of the blue (B) light emitting layer increases.

Accordingly, if the blue (B) light emitting layer emits light in the green sub-pixel, there is no big problem with a color of a green light emitted at the front viewing angle, but there is a problem with a color change of the green light emitted at the side viewing angle.

As a result, from FIGS. 2A and 2B, there is no problem with the green light emitted from the green sub-pixel if the red light emitting layer emits light in the green sub-pixel, but there is a problem with the color change of the green light emitted from the side viewing angle if the blue light emitting layer emits light.

According to an embodiment of the present disclosure, even when the blue light emitting layer emits light in the green sub-pixel, the color of the green light emitted from the side viewing angle does not change, which will be described later.

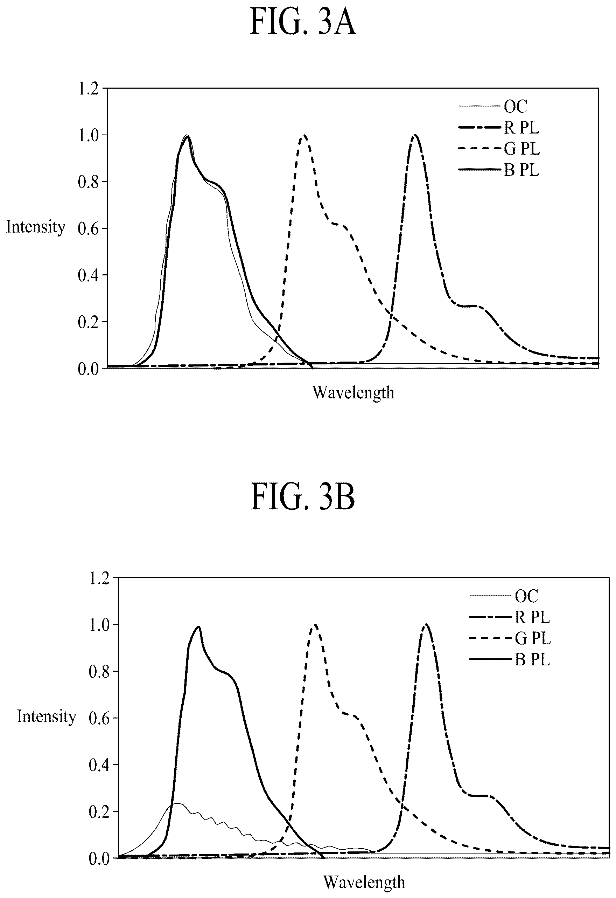

FIGS. 3A and 3B show a spectrum according to a wavelength band of a light emitting layer, and are graphs showing changes in an EL (electroluminescence) spectrum according to a viewing angle in a blue wavelength band of a blue light emitting layer. For instance, FIG. 3A is an EL spectrum at a front viewing angle, and FIG. 3B is an EL spectrum of at a side viewing angle.

As can be seen from FIGS. 3A and 3B, a product of the PL spectrum in the blue wavelength band of the blue (B) light emitting layer and an OC (Out-coupling Curve) spectrum set in consideration of microcavity characteristics finally becomes the EL spectrum in the blue wavelength band of the blue (B) light emitting layer.

As shown in FIG. 3A, the OC spectrum does not change at the front viewing angle, but as shown in FIG. 3B, the OC spectrum is shifted toward a short wavelength at the side viewing angle.

In this way, when the OC spectrum in the blue wavelength band is shifted toward the short wavelength, a peak wavelength of the EL spectrum in the blue wavelength band is shifted toward the short wavelength, and an intensity of the peak wavelength decreases. However, the OC spectrum in the blue wavelength band does not overlaps the PL spectrum in the green wavelength band of the green (G) light emitting layer and the PL spectrum in the red wavelength band of the red (R) light emitting layer.

Accordingly, if the red (R) light emitting layer or the green (G) light emitting layer emits light in the blue sub-pixel, there is no big problem with a color of a blue light emitted.

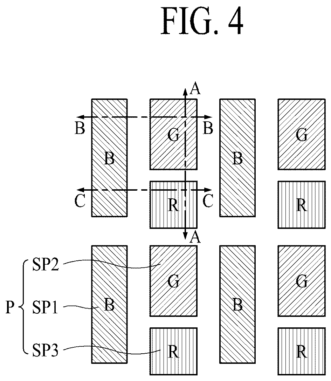

FIG. 4 is a plan view showing a pixel structure of an electroluminescent display device according to an embodiment of the present disclosure.

As shown in FIG. 4, the electroluminescent display device according to the present disclosure includes a plurality of pixels P. Each pixel P includes a first sub-pixel SP1, a second sub-pixel SP2, and a third sub-pixel SP3.

The first sub-pixel SP1 can be spaced apart from the second sub-pixel SP2 and the third sub-pixel SP3 in a first direction, for example, in a horizontal direction. The first sub-pixel SP1 can be disposed on one side and, for example, on a left side of the second sub-pixel SP2 and the third sub-pixel SP3 to face each of the second sub-pixel SP2 and the third sub-pixel SP3.

The second sub-pixel SP2 and the third sub-pixel SP3 can be spaced apart from each other in a second direction, for example, in a vertical direction.

An area of the first sub-pixel SP1 can be larger than each of an area of the second sub-pixel SP2 and an area of the third sub-pixel SP3, and the area of the second sub-pixel SP2 can be larger than the area of the third sub-pixel SP3, but is not limited thereto.

The first sub-pixel SP1 can be formed of a blue sub-pixel, the second sub-pixel SP2 can be formed of a green sub-pixel, and the third sub-pixel SP3 can be formed of a red sub-pixel, but is not limited thereto.

Each pixel P can further include a fourth sub-pixel. In addition, an arrangement of the first sub-pixel SP1, the second sub-pixel SP2, and the third sub-pixel SP3 can be variously changed.

According to an embodiment of the present disclosure, a light emitting layer can be formed in each of the sub-pixels SP1, SP2, and SP3 by a deposition process. For example, a blue light emitting layer can be deposited in the first sub-pixel SP1, a green light emitting layer can be deposited in the second sub-pixel SP2, and a red light emitting layer can be deposited in the third sub-pixel SP3.

At this time, the blue light emitting layer, the green light emitting layer, and the red light emitting layer can be formed by a deposition process using a mask such as a FMM (fine metal mask). Due to a characteristic of the process, it can be difficult to accurately pattern the light emitting layer in each of the sub-pixels SP1, SP2, and SP3. Accordingly, the light emitting layer can be formed to extend not only to the corresponding sub-pixel but also to the sub-pixel adjacent to the corresponding sub-pixel.

For example, when the blue light emitting layer is formed in the blue sub-pixel by the deposition process using the FMM mask, the deposited blue light emitting layer can penetrate below an end of the FMM mask and can move. In this case, the blue light emitting layer can enter the red sub-pixel or the green sub-pixel adjacent to the blue sub-pixel. Accordingly, the blue light emitting layer can be formed in a structure extending not only to the blue sub-pixel but also to the red sub-pixel or the green sub-pixel adjacent to the blue sub-pixel. Similarly, the red light emitting layer can extend not only to the red sub-pixel but also to the green sub-pixel or the blue sub-pixel adjacent to the red sub-pixel, and the green light emitting layer can extend not only to the green sub-pixel but also to the red sub-pixel or the blue sub-pixel adjacent to the green sub-pixel.

As shown in FIGS. 1A and 1B, when the green light emitting layer is extended to the red sub-pixel, the color change can occur in the red light emitted at the side viewing angle. And, as shown in FIGS. 2A and 2B, when the blue light emitting layer is extended to the green sub-pixel, the color change can occur in the green light emitted at the side viewing angle. Therefore, a method capable of preventing above color change is required, and various embodiments of the present disclosure capable of meeting above demand will be described as follows.

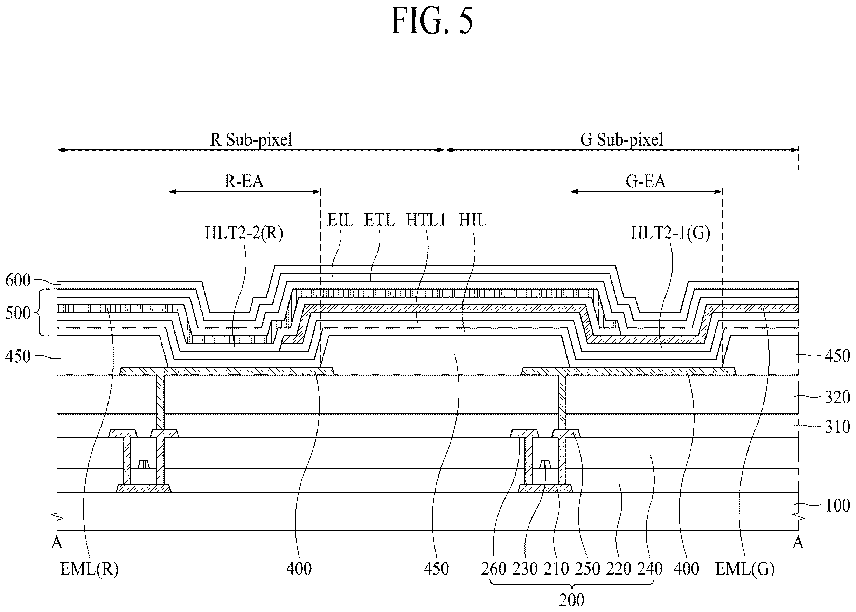

FIG. 5 is a schematic cross-sectional view of an electroluminescent display device according to an embodiment of the present disclosure, which shows a red sub-pixel (R sub-pixel) and a green sub-pixel (G sub-pixel) adjacent to each other. For instance, FIG. 5 corresponds to a cross part of the line A-A of Fig. 4 in accordance with one embodiment.

As shown in FIG. 5, the electroluminescent display device according to an embodiment of the present disclosure includes a substrate 100, a circuit element layer 200, a passivation layer 310, a planarization layer 320, a first electrode 400, a bank 450, a light emitting part 500, and a second electrode 600.

The substrate 100 can be made of glass, plastic, or semiconductor material, but is not limited thereto. The electroluminescent display device according to an embodiment of the present disclosure can be made of a top emission type, and accordingly, not only a transparent material but also an opaque material can be used as a material of the substrate 100.

The circuit element layer 200 is disposed on the substrate 100.

The circuit element layer 200 includes a driving thin film transistor disposed in each of the sub-pixels (R sub-pixel, G sub-pixel).

The driving thin film transistor includes an active layer 210 on the substrate 100, a gate insulating layer 220 on the active layer 210, a gate electrode 230 on the gate insulating layer 220, an interlayer insulating layer 240 on the gate electrode 230, and a source electrode 250 and a drain electrode 260 on the interlayer insulating layer 240.

The source electrode 250 and the drain electrode 260 are connected to one side and the other side of the active layer 210 through holes disposed in the interlayer insulating layer 240 and the gate insulating layer 220.

Although a driving thin film transistor having a top gate structure in which the gate electrode 230 is disposed on the active layer 210 is illustrated in the drawing, the present disclosure can include a driving thin film transistor having a bottom gate structure in which the gate electrode 230 is disposed under the active layer 210. In addition, although the gate insulating layer 220 is formed on an entire surface of the substrate 100, the gate insulating layer 220 can be patterned in the same manner as the gate electrode 230 under the gate electrode 230. The driving thin film transistor can be changed into various forms known in the art.

In addition, the circuit element layer 200 can further include various signal lines including gate line, data line, power line, and reference line, various thin film transistors including switching thin film transistors and sensing thin film transistors, and capacitors.

The switching thin film transistor is switched according to a gate signal supplied to the gate line to supply a data voltage supplied from the data line to the driving thin film transistor.

The driving thin film transistor is switched according to the data voltage supplied from the switching thin film transistor to generate a data current from a power source supplied from the power line and supply the data current to the first electrode 400.

The sensing thin film transistor senses a threshold voltage deviation of the driving thin film transistor, which causes image quality deterioration, and supplies a current of the driving thin film transistor to the reference line in response to a sensing control signal supplied from the gate line or a separate sensing line.

The capacitor maintains the data voltage supplied to the driving thin film transistor for one frame, and is connected to a gate terminal and a source terminal of the driving thin film transistor, respectively.

The passivation layer 310 is disposed on the circuit element layer 200. Specifically, the passivation layer 310 is disposed on the source electrode 250 and the drain electrode 260. The passivation layer 310 can be formed of an inorganic insulating material, but is not limited thereto.

The planarization layer 320 is disposed on the passivation layer 310. The planarization layer 320 can be made of an organic insulating material.

The passivation layer 310 and the planarization layer 320 include a contact hole, and the source electrode 250 can be exposed through the contact hole, and the first electrode 400 can be connected to the source electrode 250 exposed through the contact hole. In some cases, the drain electrode 260 can be exposed through the contact hole disposed in the passivation layer 310 and the planarization layer 320, and the first electrode 400 can be connected to the drain electrode 260 exposed through the contact hole.

The first electrode 400 is disposed in a red sub-pixel (R sub-pixel) and a green sub-pixel (G sub-pixel) on the planarization layer 320, respectively.

The first electrode 400 is connected to the source electrode 250 or the drain electrode 260 through a contact hole disposed in the passivation layer 310 and the planarization layer 320.

The electroluminescent display device according to an embodiment of the present disclosure can be formed by the top emission type, and accordingly, the first electrode 400 can include a reflective electrode.

The bank 450 is disposed on the planarization layer 320 and is disposed at a boundary between the red sub-pixel (R sub-pixel) and the green sub-pixel (R sub-pixel).

The bank 450 is disposed on the first electrode 400 to cover an edge of the first electrode 400. Light emitting areas R-EA and G-EA can be defined by the bank 450. Specifically, a portion of the first electrode 400 exposed without being covered by the bank 450 can become light emitting areas R-EA and G-EA. Accordingly, the red light emitting area R-EA can be disposed in the red sub-pixel (R sub-pixel or first sub-pixel), and the green light emitting area G-EA can be disposed in the green sub-pixel (G sub-pixel or second sub-pixel). The light emitting layer of the first sub-pixel can emit light having a longer wavelength than the light emitting layer of the second sub-pixel.

The light emitting part 500 is disposed in the light emitting areas R-EA and G-EA defined by the bank 450. The light emitting part 500 is disposed on the first electrode 400, particularly, on the portion of the first electrode 400 exposed without being covered by the bank 450. In addition, the light emitting part 500 can be disposed on an upper surface of the bank 450.

The light emitting part 500 includes a hole injection layer HIL, a first hole transport layer HTL1, a second hole transport layer HTL2-2(R) and HTL2-1(G) (which can be also called as additional hole transport layer), light emitting layers EML(R) and EML(G), an electron transport layer ETL, and an electron injection layer EIL.

The hole injection layer HIL is disposed on the first electrode 400 and the bank 450, and is formed to be continuous without being disconnected in the red sub-pixel (R sub-pixel) and the green sub-pixel (G sub-pixel).

The first hole transport layer HTL1 is disposed on the hole injection layer HIL, and is formed to be continuous without being disconnected in the red sub-pixel (R sub-pixel) and the green sub-pixel (G sub-pixel).

The second hole transport layers HTL2-2(R) and HTL2-1(G) are disposed on the first hole transport layer HTL1. The second hole transport layers HTL2-2(R) and HTL2-1(G) can be formed of the same material as the first hole transport layer HTL1, but can also be formed of different materials.

The second hole transport layers HTL2-2(R) and HTL2-1(G) include a 2-1th hole transport layer HTL2-1(G) disposed in the green sub-pixel (G sub-pixel) and a 2-2th hole transport layer HTL2-2(R) disposed in the red sub-pixel (R sub-pixel).

The 2-1th hole transport layer HTL2-1(G) obtains a microcavity effect in the green sub-pixel (G sub-pixel), and the 2-2th hole transport layer HTL2-2(R) obtains a microcavity effect in the red sub-pixel (R sub-pixel).

Considering that red light has a longer wavelength than green light, a thickness of the 2-2th hole transport layer HTL2-2(R) can be thicker than a thickness of the 2-1th hole transport layer HTL2-1(G).

The 2-1th hole transport layer HTL2-1(G) can be formed by a deposition process using a mask, and in this case, the 2-1th hole transport layer HTL2-1(G) may not only be formed in the green sub-pixel (G sub-pixel), but can also extend to the red sub-pixel (R sub-pixel) adjacent the green sub-pixel (G sub-pixel) and be disposed under the red light emitting layers EML(R). For example, the 2-1th hole transport layer HTL2-1(G) can extend to an area overlapping the red light emitting area R-EA of the red sub-pixel (R sub-pixel).

A thickness of an extended portion of the 2-1th hole transport layer HTL2-1(G) extending to the red sub-pixel (R sub-pixel) can be thinner than a thickness of the 2-1th hole transport layer HTL2-1(G) disposed in the green sub-pixel (G sub-pixel).

The 2-2th hole transport layer HTL2-2(R) can be formed by a deposition process using a mask, and in this case, the 2-2th hole transport layer HTL2-2(R) may not only be formed in the red sub-pixel (R sub-pixel), but can also extend to the green sub-pixel (G sub-pixel) adjacent the red sub-pixel (R sub-pixel). For example, the 2-2th hole transport layer HTL2-2(R) can extend to an area overlapping the green light emitting area G-EA of the green sub-pixel (G sub-pixel).

A thickness of an extended portion of the 2-2th hole transport layer HTL2-2(R) extending to the green sub-pixel (G sub-pixel) can be thinner than a thickness of the 2-2th hole transport layer HTL2-2(R) disposed in the red sub-pixel (R sub-pixel).

In the following embodiments, when a second hole transport layer disposed in one sub-pixel extends to another adjacent sub-pixel, a thickness of an extended portion of the second hole transport layer extending to another adjacent sub-pixel can be thinner than a thickness of the second hole transport layer disposed in one sub-pixel.

According to an embodiment of the present disclosure, the 2-1th hole transport layer HTL2-1(G) can be deposited and formed prior to the 2-2th hole transport layer HTL2-2(R), and accordingly, the 2-1th hole transport layer HTL2-1(G) can be disposed below the 2-2th hole transport layer HTL2-2(R).

The light emitting layers EML(R), EML(G) are disposed on the second hole transport layers HTL2-1(G) and HTL2-2(R).

The light emitting layers EML(R), EML(G) include a green light emitting layer EML(G) disposed in the green sub-pixel (G sub-pixel) and a red light emitting layer EML(R) disposed in the red sub-pixel (R sub-pixel).

Similar to the 2-1th hole transport layer HTL2-1(G), the green light emitting layer EML(G) can be formed by a deposition process using a mask, and in this case, the green light emitting layer EML(G) may not only be formed in the green sub-pixel (G sub-pixel) but can also extend to the red sub-pixel (R sub-pixel) adjacent the green sub-pixel (G sub-pixel). For example, the green light emitting layer EML(G) can extend to an area overlapping the red light emitting area R-EA of the red sub-pixel (R sub-pixel) or extend to the red light emitting area R-EA of the red sub-pixel (R sub-pixel).

A thickness of the extended portion of the green light emitting layer EML(G) extending to the red sub-pixel (R sub-pixel) can be thinner than a thickness of the green light emitting layer EML(G) formed in the green sub-pixel (G sub-pixel).

Similar to the 2-2th hole transport layer HTL2-2(R), the red light emitting layer EML(R) can be formed by a deposition process using a mask, and in this case, the red light emitting layer EML(R) may not only be formed in the red sub-pixel (R sub-pixel) but can also extend to the green sub-pixel (G sub-pixel) adjacent the red sub-pixel (R sub-pixel). For example, the red light emitting layer EML(R) can extend to an area overlapping the green light emitting area G-EA of the greed sub-pixel (G sub-pixel).

A thickness of the extended portion of the red light emitting layer EML(R) extending to the green sub-pixel (G sub-pixel) can be thinner than a thickness of the red light emitting layer EML(R) formed in the red sub-pixel (R sub-pixel).

In the following embodiments, when a red light emitting layer disposed in one sub-pixel extends to another adjacent sub-pixel, a thickness of an extended portion of the red light emitting layer extending to another adjacent sub-pixel can be thinner than a thickness of the red light emitting layer disposed in one sub-pixel.

According to an embodiment of the present disclosure, the 2-1th hole transport layer HTL2-1(G), the green light emitting layer EML(G), the 2-2th hole transport layer HTL2-2(R), and the red light emitting layer EML(R) can be formed in order by the deposition process. Accordingly, the green light emitting layer EML(G) can be disposed on the 2-1th hole transport layer HTL2-1(G), the 2-2th hole transport layer HTL2-2(R) can be disposed on the green light emitting layer EML(G), and the red light emitting layer EML(R) can be disposed on the 2-2th hole transport layer HTL2-2(R).

The electron transport layer ETL is disposed on the light emitting layers EML(R), EML(G), and is formed to be continuous without being disconnected in the red sub-pixel (R sub-pixel) and the green sub-pixel (G sub-pixel).

The electron injection layer EIL is disposed on the electron transport layer ETL, and is formed to be continuous without being disconnected in the red sub-pixel (R sub-pixel) and the green sub-pixel (G sub-pixel).

The second electrode 600 is disposed on the light emitting part 500. The second electrode 600 is formed to be continuous without being disconnected in the red sub-pixel (R sub-pixel) and the green sub-pixel (G sub-pixel).

The electroluminescent display device according to an embodiment of the present disclosure can be configured by the top emission type, and thus the second electrode 600 can include a transparent electrode or a translucent electrode.

An encapsulation layer can be additionally disposed on the second electrode 600.

According to an embodiment of the present disclosure, the 2-1th hole transport layer HTL2-1(G) is deposited and then the green light emitting layer EML(G) is deposited and then the 2-2th hole transport layer HTL2-2(R) is deposited and then the red light emitting layer EML(R) is deposited.

Accordingly, in a partial area of the green sub-pixel (G sub-pixel), a partial area of the red sub-pixel (R sub-pixel), and a boundary area between the green sub-pixel (G sub-pixel) and the red sub-pixel (R sub-pixel), the green light emitting layer EML(G), the 2-2th hole transport layer HTL2-2(R), and the red light emitting layer EML(R) can be sequentially disposed on the 2-1th hole transport layer HTL2-1(G).

That is, the 2-2th hole transport layer HTL2-2(R) can be disposed between the green light emitting layer EML(G) and the red light emitting layer EML(R) in the partial area of the green sub-pixel (G sub-pixel), the partial area of the red sub-pixel (R sub-pixel), and the boundary area between the green sub-pixel (G sub-pixel) and the red sub-pixel (R sub-pixel).

As such, in the partial area of the red sub-pixel (R sub-pixel), for example, in the red light emitting area R-EA, the green light emitting layer EML(G) can be disposed below the red light emitting layer EML(R) with the 2-2th hole transport layer HTL2-2(R) interposed therebetween. Accordingly, the 2-2th hole transport layer HTL2-2(R) can function as a block layer blocking electron movement to the green light emitting layer EML(G). Accordingly, although the green light emitting layer EML(G) is extended in the red light emitting area R-EA, electron movement to the green light emitting layer EML(G) can be blocked by the 2-2th hole transport layer HTL2-2(R), and thus light emission may not occur in the green light emitting layer EML(G). As a result, a color of red light emitted from the red light emitting layer EML(R) of the red sub-pixel (R sub-pixel) does not change.

In addition, in the green light emitting area G-EA, the red light emitting layer EML(R) can be disposed on the green light emitting layer EML(G) with the 2-2th hole transport layer HTL2-2(R) interposed therebetween. Accordingly, there is no block layer blocking electron movement to the red light emitting layer EML(R), and the red light emitting layer EML(R) can emit light in the green light emitting area G-EA. However, as shown in FIGS. 2A and 2B described above, since the OC spectrum of the green wavelength band does not shift toward the long wavelength, the light emitted from the red light emitting layer EML(R) is not emitted to the green light emitting area G-EA due to a destructive interference. As a result, a color of the green light emitted from the green light emitting layer EML(G) of the green sub-pixel (G sub-pixel) does not change.

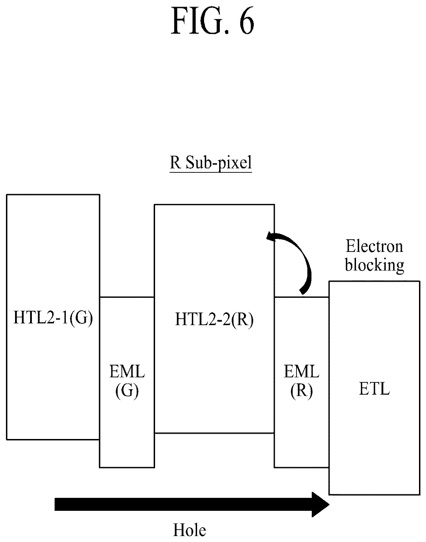

FIG. 6 is an energy band diagram of a light emitting part of a red sub-pixel according to an embodiment of the present disclosure.

As shown in FIG. 6, in the case of a red sub-pixel (R sub-pixel), a 2-1th hole transport layer HTL2-1(G), a green light emitting layer EML(G), a 2-2th hole transport layer HTL2-2(R), a red light emitting layer EML(R), and an electron transport layer ETL can be sequentially formed.

In this case, the hole can move smoothly from the 2-1th hole transport layer HTL2-1(G) to the green light emitting layer EML(G), the 2-2th hole transport layer HTL2-2(R), and the red light emitting layer EML(R), so that the hole can be smoothly supplied to the green light emitting layer EML(G) and the red light emitting layer EML(R).

However, electrons can move smoothly from the electron transport layer ETL to the red light emitting layer EML(R), but a LUMO (Lowest Unoccupied Molecular Orbital) level of the 2-2th hole transport layer HTL2-2(R) is so high that electrons cannot move to the 2-2th hole transport layer HTL2-2(R), and accordingly, electrons are supplied smoothly to the red light emitting layer EML(R), but electrons are not supplied smoothly to the green light emitting layer EML(G).

As a result, light emission occurs by a combination of holes and electrons in the red light emitting layer EML(R), but light emission does not occur because a combination of holes and electrons is impossible in the green light emitting layer EML(G).

As described above, according to an embodiment of the present disclosure, since the 2-2th hole transport layer HTL2-2(R) in the red sub-pixel (R sub-pixel) can function as a block layer that blocks the movement of electrons to the green light emitting layer EML(G), even if the green light emitting layer EML(G) is disposed in the red sub-pixel (R sub-pixel), light emission does not occur in the green light emitting layer EML(G) and the color of red light emitted from the red emission layer EML(R) does not change.

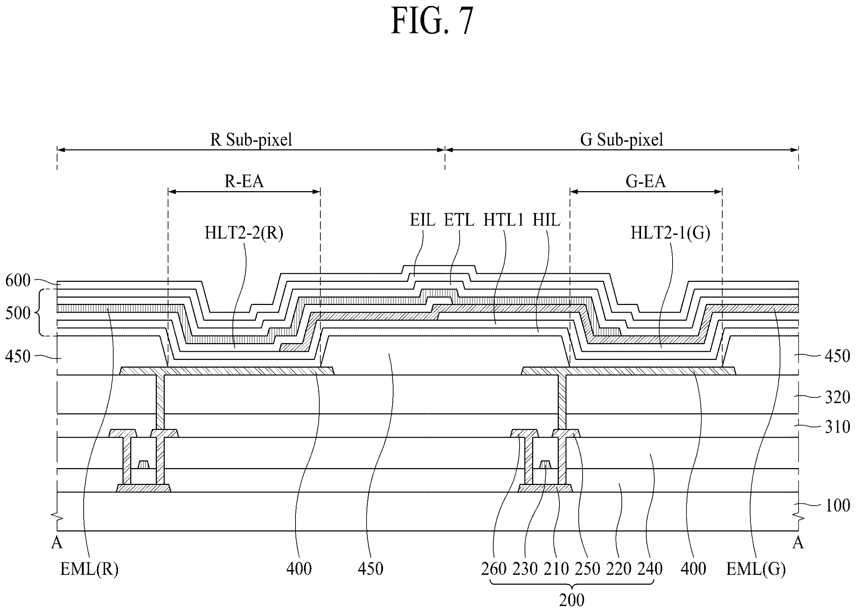

FIG. 7 is a schematic cross-sectional view of an electroluminescent display device according to another embodiment of the present disclosure, which shows a red sub-pixel and a green sub-pixel adjacent to each other. For instance, FIG. 7 corresponds to a cross section of line A-A of FIG. 4 according to another embodiment.

FIG. 7 is different from the electroluminescence display device according to FIG. 5 described above in that a configuration of the second hole transport layers HTL2-2(R) and HTL2-1(G) is changed. Therefore, hereinafter, different configurations will be described.

According to FIG. 5 described above, the 2-1th hole transport layer HTL2-1(G) is formed in the same pattern as the green light emitting layer EML(G), and the 2-2th hole transport layer HTL2-2(R) is formed in the same pattern as the red light emitting layer EML(R).

That is, according to FIG. 5 described above, the 2-1th hole transport layer HTL2-1(G) and the green light emitting layer EML(G) extend from the green sub-pixel (G sub-pixel) to the red light emitting area R-EA of the red sub-pixel (R sub-pixel) adjacent the green sub-pixel (G sub-pixel), and the 2-2th hole transport layer HTL2-2(R) and the red light emitting layer EML(R) extend from the red sub-pixel (R sub-pixel) to the green light emitting area G-EA of the green sub-pixel (G sub-pixel) adjacent the red sub-pixel (R sub-pixel).

Accordingly, according to FIG. 5 described above, in each of the red sub-pixel (R sub-pixel) and the green sub-pixels (G sub-pixel), the green light emitting layer EML(G) and the red light emitting layer EML(R) are not in contact with each other and are spaced from each other, for example, spaced up and down with the 2-2th hole transport layer HTL2-2(R) interposed therebetween.

In addition, according to FIG. 5 described above, in each of the red sub-pixel (R sub-pixel) and the green sub-pixel (G sub-pixel), the 2-1th hole transport layer HTL2-1(G) and the 2-2th hole transport layer HTL2-2(R) are spaced up and down with the green light emitting layer EML(G) interposed therebetween, but in the red sub-pixel (R sub-pixel), the 2-1th hole transport layer HTL2-1(G) can be in contact with the 2-2th hole transport layer HTL2-2(R), for example, one end of the 2-1th hole transport layer HTL2-1(G) is in contact with the 2-2th hole transport layer HTL2-2(R).

On the other hand, according to FIG. 7, the 2-1th hole transport layer HTL2-1(G) is formed in a pattern different from the green light emitting layer EML(G), and the 2-2th hole transport layer HTL2-2(R) is formed in a pattern different from the red light emitting layer EML(R).

Specifically, the green light emitting layer EML(G) extends from the green sub-pixel (G sub-pixel) to the red light emitting area R-EA of the red sub-pixel (R sub-pixel) adjacent the green sub-pixel (G sub-pixel), but the 2-1th hole transport layer HTL2-1(G) is disposed in the green sub-pixel (G sub-pixel) and does not extend to the red sub-pixel (R sub-pixel) adjacent the green sub-pixel (G sub-pixel), for example, to the red light emitting area R-EA.

In addition, the red light emitting layer EML(R) extends from the red sub-pixel (R sub-pixel) to the green light emitting area G-EA of the green sub-pixel (G sub-pixel) adjacent the red sub-pixel (R sub-pixel), but the 2-2th hole transport layer HTL2-2(R) is disposed in the red sub-pixel (R sub-pixel) and does not extend to the green sub-pixel (G sub-pixel) adjacent the red sub-pixel (R sub-pixel), for example, to the green light emitting area G-EA.

Accordingly, in the red sub-pixel (R sub-pixel), the green light emitting layer EML(G) and the red light emitting layer EML(R) are not in contact with each other and are spaced up and down with the 2-2th hole transport layer HTL2-2(R) interposed therebetween, but in the green sub-pixel (G sub-pixel), the red light emitting layer EML(R) can contact the green light emitting layer EML(G), for example, a lower surface of the red light emitting layer EML(R) is in contact with an upper surface of the green light emitting layer EML(G).

In addition, the 2-1th hole transport layer HTL2-1(G) and the 2-2th hole transport layer HTL2-2(R) are spaced up and down with the green light emitting layer EML(G) interposed therebetween in a boundary area between the red sub-pixel (R sub-pixel) and the green sub-pixel (G sub-pixel), and the 2-1th hole transport layer HTL2-1(G) and the 2-2th hole transport layer HTL2-2(R) are not in contact with each other in an entire area of the red sub-pixel (R sub-pixel) and the green sub-pixel (G sub-pixel).

According to another embodiment of the present disclosure as shown in FIG. 7, in the red light emitting area R-EA of the red sub-pixel (R sub-pixel), the green light emitting layer EML(G) can be disposed below the red light emitting layer EML(R) with the 2-2th hole transport layer HTL2-2(R) interposed therebetween. Accordingly, the 2-2th hole transport layer HTL2-2(R) can function as a block layer blocking electron movement to the green light emitting layer EML(G). Accordingly, although the green light emitting layer EML(G) is extended in the red light emitting area R-EA, electron movement to the green light emitting layer EML(G) can be blocked by the 2-2th hole transport layer HTL2-2(R), and thus light emission may not occur in the green light emitting layer EML(G). As a result, a color of red light emitted from the red light emitting layer EML(R) of the red sub-pixel (R sub-pixel) does not change.

In addition, in the green light emitting area G-EA, the red light emitting layer EML(R) is in contact with the green light emitting layer EML(G) and disposed on the green light emitting layer EML(G). Accordingly, there is no block layer blocking electron movement to the red light emitting layer EML(R), and the red light emitting layer EML(R) can emit light in the green light emitting area G-EA. However, as shown in FIGS. 2A and 2B described above, since the OC spectrum of the green wavelength band does not shift toward the long wavelength, the light emitted from the red light emitting layer EML(R) is not emitted to the green light emitting area G-EA due to a destructive interference. As a result, a color of the green light emitted from the green light emitting layer EML(G) of the green sub-pixel (G sub-pixel) does not change.

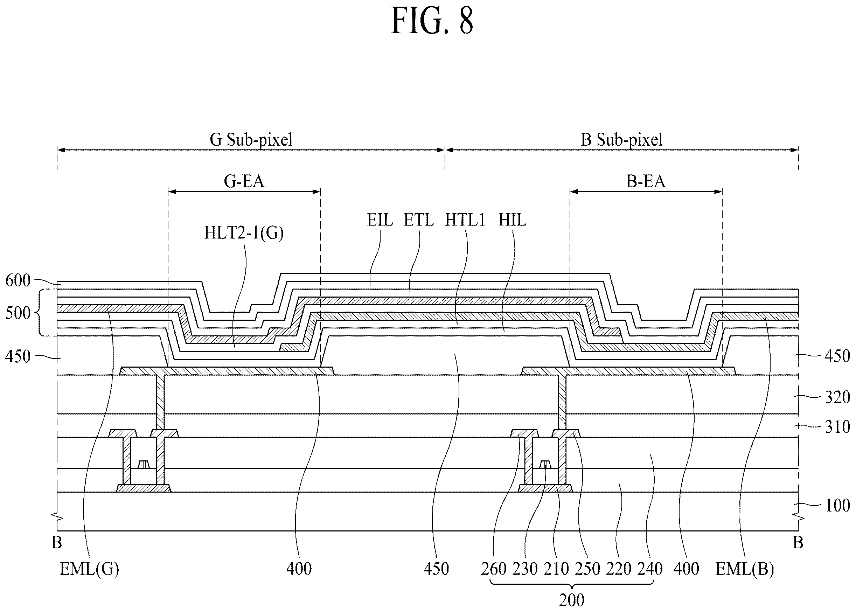

FIG. 8 is a schematic cross-sectional view of an electroluminescent display device according to an embodiment of the present disclosure, which shows a green sub-pixel and a blue sub-pixel adjacent to each other. FIG. 8 corresponds to a cross section of line B-B of FIG. 4 according to an embodiment.

As shown in FIG. 8, the electroluminescent display device according to an embodiment of the present disclosure includes a substrate 100, a circuit element layer 200, a passivation layer 310, a planarization layer 320, a first electrode 400, a bank 450, a light emitting part 500, and a second electrode 600.

Since configurations of the substrate 100, the circuit element layer 200, the passivation layer 310, the planarization layer 320, the first electrode 400, the bank 450, and the second electrode 600 are the same as those of FIG. 5, a repeated description thereof will be omitted.

The light emitting part 500 includes a hole injection layer HIL, a first hole transport layer HTL1, a 2-1th hole transport layer HTL2-1(G), light emitting layers EML(G) and EML(B), an electron transport layer ETL, and an electron injection layer EIL.

The hole injection layer HIL is formed to be continuous without being disconnected in the green sub-pixel (G sub-pixel) and the blue sub-pixel (B sub-pixel).

The first hole transport layer HTL1 is disposed on the hole injection layer HIL, and is formed to be continuous without being disconnected in the green sub-pixel (G sub-pixel) and the blue sub-pixel (B sub-pixel).

The 2-1th hole transport layer HTL2-1(G) is disposed on the first hole transport layer HTL1. The 2-1th hole transport layer HTL2-1(G) can be formed of the same material as the first hole transport layer HTL1, but can also be formed of different materials. Another hole transport layer, for example, the 2-2th hole transport layer HTL2-2(R) in Fig. 5 or 7 can be disposed between the first hole transport layer HTL1 and the red light emitting layer of the red sub-pixel.

The 2-1th hole transport layer HTL2-1(G) is disposed in the green sub-pixel (G sub-pixel) and obtains a microcavity effect in the green sub-pixel (G sub-pixel).

In the blue sub-pixel (B sub-pixel), a microcavity effect can be obtained by the first hole transport layer HTL1, and a separate second hole transport layer may not be formed on the first hole transport layer HTL1.

The 2-1th hole transport layer HTL2-1(G) can be formed by a deposition process using a mask, and in this case, the 2-1th hole transport layer HTL2-1(G) may not only be formed in the green sub-pixel (G sub-pixel), but can also extend to the blue sub-pixel (B sub-pixel) adjacent the green sub-pixel (G sub-pixel). For example, the 2-1th hole transport layer HTL2-1(G) can extend to an area overlapping the blue light emitting area B-EA of the blue sub-pixel (B sub-pixel).

The light emitting layers EML(G), EML(B) include a green light emitting layer EML(G) disposed in the green sub-pixel (G sub-pixel) and a blue light emitting layer EML(B) disposed in the blue sub-pixel (B sub-pixel).

The green light emitting layer EML(G) can be formed by a deposition process using a mask, and in this case, the green light emitting layer EML(G) may not only be formed in the green sub-pixel (G sub-pixel) but can also extend to the blue sub-pixel (B sub-pixel) adjacent the green sub-pixel (G sub-pixel). For example, the green light emitting layer EML(G) can extend to an area overlapping the blue light emitting area B-EA of the blue sub-pixel (B sub-pixel).

The blue light emitting layer EML(B) can be formed by a deposition process using a mask, and in this case, the blue light emitting layer EML(B) may not only be formed in the blue sub-pixel (B sub-pixel) but can also extend to the green sub-pixel (G sub-pixel) adjacent the blue sub-pixel (B sub-pixel). For example, the blue light emitting layer EML(B) can extend to an area overlapping the green light emitting area G-EA of the green sub-pixel (G sub-pixel).

According to an embodiment of the present disclosure, the blue light emitting layer EML(B) can be deposited and formed prior to the green light emitting layer EML(G), and accordingly, the blue light emitting layer EML(B) can be disposed below the green light emitting layer EML(G).

According to an embodiment of the present disclosure, the first hole transport layer HTL1, the blue light emitting layer EML(B), the 2-1th hole transport layer HTL2-1(G) and the green light emitting layer EML(G) can be formed in order by the deposition process. Accordingly, the blue light emitting layer EML(B) can be disposed on the first hole transport layer HTL1, the 2-1th hole transport layer HTL2-1(G) can be disposed on the blue light emitting layer EML(B), and the green light emitting layer EML(G) can be disposed on the 2-1th hole transport layer HTL2-1(G).

The electron transport layer ETL is disposed on the light emitting layers EML(G), EML(B), and is formed to be continuous without being disconnected in the green sub-pixel (G sub-pixel) and the blue sub-pixel (B sub-pixel).

The electron injection layer EIL is disposed on the electron transport layer ETL, and is formed to be continuous without being disconnected from the green sub-pixel (G sub-pixel) and the blue sub-pixel (B sub-pixel).

According to an embodiment of the present disclosure, the first hole transport layer HTL1 is deposited and then the blue light emitting layer EML(B) is deposited and then the 2-1th hole transport layer HTL2-1(G) is deposited and then the green light emitting layer EML(G) is deposited.

Accordingly, in a partial area of the green sub-pixel (G sub-pixel), a partial area of the blue sub-pixel (B sub-pixel), and a boundary area between the green sub-pixel (G sub-pixel) and the blue sub-pixel (B sub-pixel), the blue light emitting layer EML(B), the 2-1th hole transport layer HTL2-1(G), and the green light emitting layer EML(G) can be sequentially disposed on the first hole transport layer HTL1.

That is, the 2-1th hole transport layer HTL2-1(G) can be disposed between the green light emitting layer EML(G) and the blue light emitting layer EML(B) in the partial area of the green sub-pixel (G sub-pixel), the partial area of the blue sub-pixel (B sub-pixel), and the boundary area between the green sub-pixel (G sub-pixel) and the blue sub-pixel (B sub-pixel). The blue light emitting layer EML(B) and the green light emitting layer EML(G) can be spaced apart from each other with the 2-1th hole transport layer HTL2-1(G) interposed therebetween without contacting each other in the blue sub-pixel (B sub-pixel) and the green sub-pixel (G sub-pixel).

As such, in the partial area of the green sub-pixel (G sub-pixel), for example, in the green light emitting area G-EA, the blue light emitting layer EML(B) can be disposed below the green light emitting layer EML(G) with the 2-1th hole transport layer HTL2-1(G) interposed therebetween. Accordingly, the 2-1th hole transport layer HTL2-1(G) can function as a block layer blocking electron movement to the blue light emitting layer EML(B). Accordingly, although the blue light emitting layer EML(B) is extended in the green light emitting area G-EA, electron movement to the blue light emitting layer EML(B) can be blocked by the 2-1th hole transport layer HTL2-1(G), and thus light emission may not occur in the blue light emitting layer EML(B). As a result, a color of green light emitted from the green light emitting layer EML(G) of the green sub-pixel (G sub-pixel) does not change.

In addition, in the blue light emitting area B-EA, the green light emitting layer EML(G) can be disposed on the blue light emitting layer EML(B) with the 2-1th hole transport layer HTL2-1(G) interposed therebetween. Accordingly, there is no block layer blocking electron movement to the green light emitting layer EML(G), and the green light emitting layer EML(G) can emit light in the blue light emitting area B-EA. However, as shown in FIGS. 3A and 3B described above, since the OC spectrum of the blue wavelength band does not overlap the PL spectrum of the green wavelength band in the green light emitting layer EML(G), the light emitted from the green light emitting layer EML(G) is not emitted to the blue light emitting area B-EA due to a destructive interference. As a result, a color of the blue light emitted from the blue light emitting layer EML(B) of the blue sub-pixel (B sub-pixel) does not change.

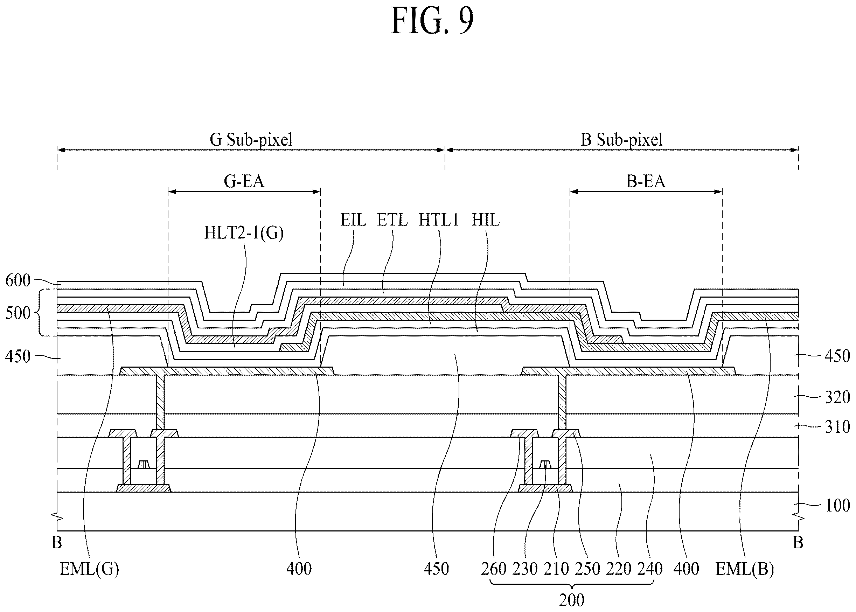

FIG. 9 is a schematic cross-sectional view of an electroluminescent display device according to another embodiment of the present disclosure, which shows a green sub-pixel and a blue sub-pixel adjacent to each other. For instance, FIG. 9 corresponds to a cross section of line B-B of FIG. 4 according to another embodiment.

FIG. 9 is different from the electroluminescence display device according to FIG. 8 described above in that the configuration of the 2-1th hole transport layer HTL2-1(G) is changed. Therefore, different configurations will be described below.

According to FIG. 8 described above, the 2-1th hole transport layer HTL2-1(G) is formed in the same pattern as the green light emitting layer EML(G).

That is, according to FIG. 8 described above, the 2-1th hole transport layer HTL2-1(G) and the green light emitting layer EML(G) extend from the green sub-pixel (G sub-pixel) to the blue light emitting area B-EA of the blue sub-pixel (B sub-pixel) adjacent the green sub-pixel (G sub-pixel).

Accordingly, according to FIG. 8 described above, in each of the green sub-pixel (G sub-pixel) and the blue sub-pixel (B sub-pixel), the green light emitting layer EML(G) and the blue light emitting layer EML(B) are not in contact with each other and are spaced up and down with the 2-1th hole transport layer HTL2-1(G) interposed therebetween.

On the other hand, according to FIG. 9, the 2-1th hole transport layer HTL2-1(G) is formed in a pattern different from the green light emitting layer EML(G).

Specifically, the green light emitting layer EML(G) extends from the green sub-pixel (G sub-pixel) to the blue light emitting area B-EA of the blue sub-pixel (B sub-pixel) adjacent the green sub-pixel (G sub-pixel), but the 2-1th hole transport layer HTL2-1(G) is formed in the green sub-pixel (G sub-pixel) and does not extend to the blue sub-pixel (B sub-pixel) adjacent the green sub-pixel (G sub-pixel), for example, the blue light emitting area B-EA.

Accordingly, in the green sub-pixel (G sub-pixel), the green light emitting layer EML(G) and the blue light emitting layer EML(B) are not in contact with each other and are spaced up and down with the 2-1th hole transport layer HTL2-1(R) interposed therebetween, but in the blue sub-pixel (B sub-pixel), a lower surface of the green light emitting layer EML(G) is in contact with an upper surface of the blue light emitting layer EML(B).

According to another embodiment of the present disclosure as shown in FIG. 9, in the green light emitting area G-EA of the green sub-pixel (G sub-pixel), the blue light emitting layer EML(B) can be disposed below the green light emitting layer EML(G) and not contact each other with the 2-1th hole transport layer HTL2-1(G) interposed therebetween. Accordingly, the 2-1th hole transport layer HTL2-1(G) can function as a block layer blocking electron movement to the blue light emitting layer EML(B). Accordingly, although the blue light emitting layer EML(B) is extended in the green light emitting area G-EA, electron movement to the blue light emitting layer EML(B) can be blocked by the 2-1th hole transport layer HTL2-1(G), and thus light emission may not occur in the blue light emitting layer EML(B). As a result, a color of green light emitted from the green light emitting layer EML(G) of the green sub-pixel (G sub-pixel) does not change.

In addition, in the blue light emitting area B-EA, the green light emitting layer EML(G) is in contact with the blue light emitting layer EML(B) and disposed on the blue light emitting layer EML(B). Accordingly, there is no block layer blocking electron movement to the green light emitting layer EML(G), and the green light emitting layer EML(G) can emit light in the blue light emitting area B-EA. However, as shown in FIGS. 3A and 3B described above, since the OC spectrum of the blue wavelength band does not overlap the PL spectrum of the green wavelength band in the green light emitting layer EML(G), the light emitted from the green light emitting layer EML(G) is not emitted to the blue light emitting area B-EA due to a destructive interference. As a result, a color of the blue light emitted from the blue light emitting layer EML(B) of the blue sub-pixel (B sub-pixel) does not change.

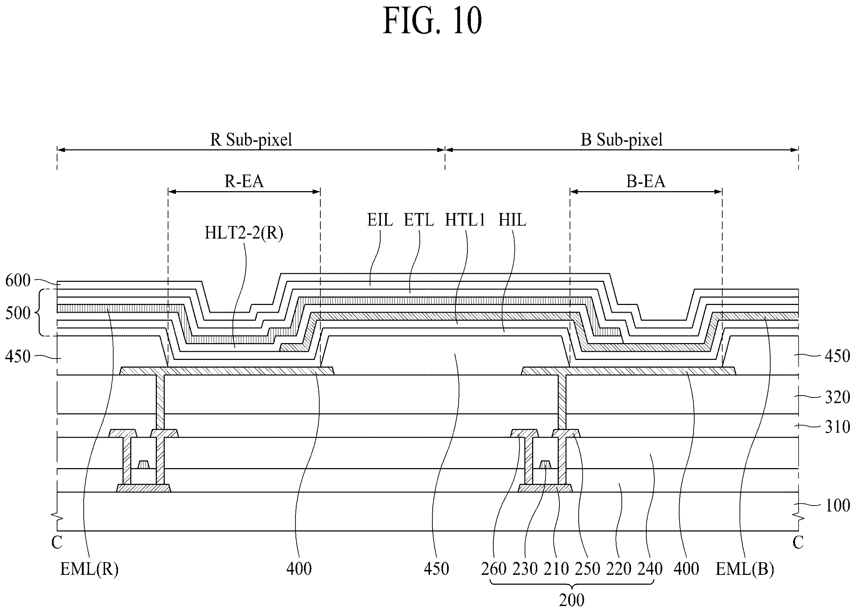

FIG. 10 is a schematic cross-sectional view of an electroluminescent display device according to an embodiment of the present disclosure, which shows a red sub-pixel and a blue sub-pixel adjacent to each other. For instance, FIG. 10 corresponds to a cross section of line C-C of FIG. 4 according to an embodiment.

As shown in FIG. 10, the electroluminescent display device according to an embodiment of the present disclosure includes a substrate 100, a circuit element layer 200, a passivation layer 310, a planarization layer 320, a first electrode 400, a bank 450, a light emitting part 500, and a second electrode 600.

Since configurations of the substrate 100, the circuit element layer 200, the passivation layer 310, the planarization layer 320, the first electrode 400, the bank 450, and the second electrode 600 are the same as those of FIG. 5, a repeated description thereof will be omitted.

The light emitting part 500 includes a hole injection layer HIL, a first hole transport layer HTL1, a 2-2th hole transport layer HTL2-2(R), light emitting layers EML(R) and EML(B), an electron transport layer ETL, and an electron injection layer EIL.

The hole injection layer HIL is formed to be continuous without being disconnected in the red sub-pixel (R sub-pixel or first sub-pixel) and the blue sub-pixel (B sub-pixel or second sub-pixel).

The first hole transport layer HTL1 is disposed on the hole injection layer HIL, and is formed to be continuous without being disconnected in the red sub-pixel (R sub-pixel) and the blue sub-pixel (B sub-pixel).

The 2-2th hole transport layer HTL2-2(R) is disposed on the first hole transport layer HTL1. The 2-2th hole transport layer HTL2-2(R) can be formed of the same material as the first hole transport layer HTL1, but can also be formed of different materials.

The 2-1th hole transport layer HTL2-1(R) is disposed in the red sub-pixel (R sub-pixel) and obtains a microcavity effect in the red sub-pixel (R sub-pixel).

In the blue sub-pixel (B sub-pixel), a microcavity effect can be obtained by the first hole transport layer HTL1, and a separate second hole transport layer may not be formed on the first hole transport layer HTL1.

The 2-2th hole transport layer HTL2-2(R) can be formed by a deposition process using a mask, and in this case, the 2-2th hole transport layer HTL2-2(R) may not only be formed in the red sub-pixel (R sub-pixel), but can also extend to the blue sub-pixel (B sub-pixel) adjacent the red sub-pixel (R sub-pixel). For example, the 2-2th hole transport layer HTL2-2(R) can extend to an area overlapping the blue light emitting area B-EA of the blue sub-pixel (B sub-pixel).

The light emitting layers EML(R), EML(B) include a red light emitting layer EML(R) disposed in the red sub-pixel (R sub-pixel) and a blue light emitting layer EML(B) disposed in the blue sub-pixel (B sub-pixel).

The red light emitting layer EML(R) can be formed by a deposition process using a mask, and in this case, the red light emitting layer EML(R) may not only be formed in the red sub-pixel (R sub-pixel) but can also extend to the blue sub-pixel (B sub-pixel) adjacent the red sub-pixel (R sub-pixel). For example, the red light emitting layer EML(R) can extend to an area overlapping the blue light emitting area B-EA of the blue sub-pixel (B sub-pixel).

The blue light emitting layer EML(B) can be formed by a deposition process using a mask, and in this case, the blue light emitting layer EML(B) may not only be formed in the blue sub-pixel (B sub-pixel) but can also extend to the red sub-pixel (R sub-pixel) adjacent the blue sub-pixel (B sub-pixel). For example, the blue light emitting layer EML(B) can extend to an area overlapping the red light emitting area R-EA of the red sub-pixel (R sub-pixel).

According to an embodiment of the present disclosure, the blue light emitting layer EML(B) can be deposited and formed prior to the red light emitting layer EML(R), and accordingly, the blue light emitting layer EML(B) can be disposed below the red light emitting layer EML(R).

According to an embodiment of the present disclosure, the first hole transport layer HTL1, the blue light emitting layer EML(B), the 2-2th hole transport layer HTL2-2(R) and the red light emitting layer EML(R) can be formed in order by the deposition process. Accordingly, the blue light emitting layer EML(B) can be disposed on the first hole transport layer HTL1, the 2-2th hole transport layer HTL2-2(R) can be disposed on the blue light emitting layer EML(B), and the red light emitting layer EML(R) can be disposed on the 2-2th hole transport layer HTL2-2(R).

The electron transport layer ETL is disposed on the light emitting layers EML(R), EML(B), and is formed to be continuous without being disconnected in the red sub-pixel (R sub-pixel) and the blue sub-pixel (B sub-pixel).

The electron injection layer EIL is disposed on the electron transport layer ETL, and is formed to be continuous without being disconnected in the red sub-pixel (R sub-pixel) and the blue sub-pixel (B sub-pixel).

According to an embodiment of the present disclosure, the first hole transport layer HTL1 is deposited and then the blue light emitting layer EML(B) is deposited and then the 2-2th hole transport layer HTL2-2(R) is deposited and then the red light emitting layer EML(R) is deposited.

Accordingly, in a partial area of the red sub-pixel (R sub-pixel), a partial area of the blue sub-pixel (B sub-pixel), and a boundary area between the red sub-pixel (R sub-pixel) and the blue sub-pixel (B sub-pixel), the blue light emitting layer EML(B), the 2-2th hole transport layer HTL2-2(R), and the red light emitting layer EML(R) can be sequentially disposed on the first hole transport layer HTL1.

That is, the 2-2th hole transport layer HTL2-2(R) can be disposed between the red light emitting layer EML(R) and the blue light emitting layer EML(B) in the partial area of the red sub-pixel (R sub-pixel), the partial area of the blue sub-pixel (B sub-pixel), and the boundary area between the red sub-pixel (R sub-pixel) and the blue sub-pixel (B sub-pixel).

As such, in the partial area of the red sub-pixel (R sub-pixel), for example, in the red light emitting area R-EA, the blue light emitting layer EML(B) can be disposed below the red light emitting layer EML(R) with the 2-2th hole transport layer HTL2-2(R) interposed therebetween. Accordingly, the 2-2th hole transport layer HTL2-2(R) can function as a block layer blocking electron movement to the blue light emitting layer EML(B). Accordingly, although the blue light emitting layer EML(B) is extended in the red light emitting area R-EA, electron movement to the blue light emitting layer EML(B) can be blocked by the 2-2th hole transport layer HTL2-2(R), and thus light emission may not occur in the blue light emitting layer EML(B). As a result, a color of red light emitted from the red light emitting layer EML(R) of the red sub-pixel (R sub-pixel) does not change.

Separately, even if electrons move to the blue light emitting layer EML(B), the blue light emitting layer EML(B) can emit light in the red light emitting area R-EA. However, as shown in FIGS. 1A and 1B described above, since the OC spectrum of the red wavelength band does not overlap the PL spectrum of the blue wavelength band in the blue light emitting layer EML(B), the light emitted from the blue light emitting layer EML(B) is not emitted to the red light emitting area R-EA due to a destructive interference. As a result, a color of the red light emitted from the red light emitting layer EML(R) of the red sub-pixel (R sub-pixel) does not change.

In addition, in the blue light emitting area B-EA, the red light emitting layer EML(R) can be disposed on the blue light emitting layer EML(B) with the 2-2th hole transport layer HTL2-2(R) interposed therebetween. Accordingly, there is no block layer blocking electron movement to the red light emitting layer EML(R), and the red light emitting layer EML(R) can emit light in the blue light emitting area B-EA. However, as shown in FIGS. 3A and 3B described above, since the OC spectrum of the blue wavelength band does not overlap the PL spectrum of the red wavelength band in the red light emitting layer EML(R), the light emitted from the red light emitting layer EML(R) is not emitted to the blue light emitting area B-EA due to a destructive interference. As a result, a color of the blue light emitted from the blue light emitting layer EML(B) of the blue sub-pixel (B sub-pixel) does not change.

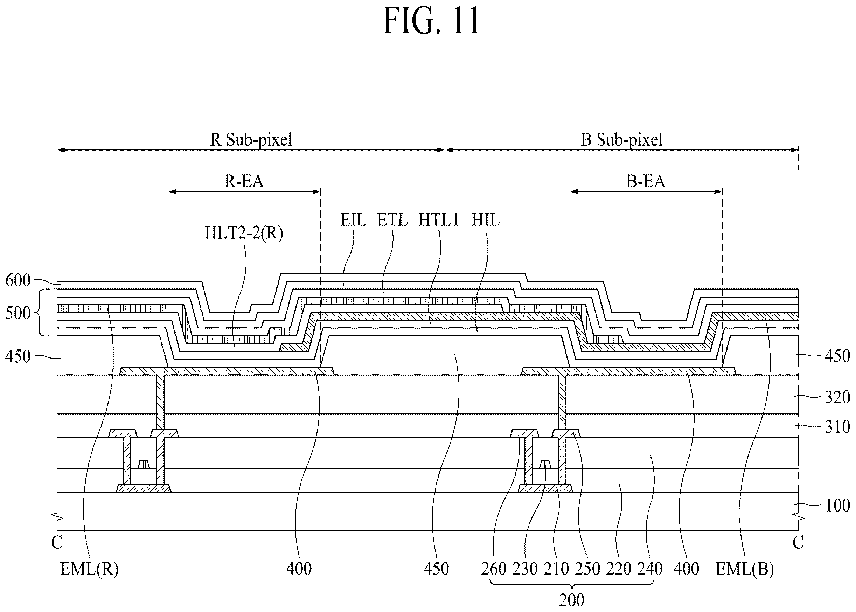

FIG. 11 is a schematic cross-sectional view of an electroluminescent display device according to another embodiment of the present disclosure, which shows a red sub-pixel and a blue sub-pixel adjacent to each other. FIG. 11 corresponds to a cross section of line C-C of FIG. 4 according to another embodiment.

FIG. 11 is different from the electroluminescence display device according to FIG. 10 described above in that the configuration of the 2-2th hole transport layer HTL2-2(R) is changed. Therefore, different configurations will be described below.

According to FIG. 10 described above, the 2-2th hole transport layer HTL2-2(R) is formed in the same pattern as the red light emitting layer EML(R).

That is, according to FIG. 10 described above, the 2-2th hole transport layer HTL2-2(R) and the red light emitting layer EML(R) extend from the red sub-pixel (R sub-pixel) to the blue light emitting area B-EA of the blue sub-pixel (B sub-pixel) adjacent the red sub-pixel (R sub-pixel).

Accordingly, according to FIG. 10 described above, in each of the red sub-pixel (R sub-pixel) and the blue sub-pixel (B sub-pixel), the red light emitting layer EML(R) and the blue light emitting layer EML(B) are not in contact with each other and are spaced up and down with the 2-2th hole transport layer HTL2-2(R) interposed therebetween.

On the other hand, according to FIG. 11, the 2-2th hole transport layer HTL2-2(R) is formed in a pattern different from the red light emitting layer EML(R).

Specifically, the red light emitting layer EML(R) extends from the red sub-pixel (R sub-pixel) to the blue light emitting area B-EA of the blue sub-pixel (B sub-pixel) adjacent the red sub-pixel (R sub-pixel), but the 2-2th hole transport layer HTL2-2(R) is formed in the red sub-pixel (R sub-pixel) and does not extend to the blue sub-pixel (B sub-pixel) adjacent the red sub-pixel (R sub-pixel), for example, the blue light emitting area B-EA.

Accordingly, in the red sub-pixel (R sub-pixel), the red light emitting layer EML(R) and the blue light emitting layer EML(B) are not in contact with each other and are spaced up and down with the 2-2th hole transport layer HTL2-2(R) interposed therebetween, but in the blue sub-pixel (B sub-pixel), a lower surface of the red light emitting layer EML(R) is in contact with an upper surface of the blue light emitting layer EML(B).

According to another embodiment of the present disclosure as shown in FIG. 11, in the red light emitting area R-EA of the red sub-pixel (R sub-pixel), the blue light emitting layer EML(B) can be disposed below the red light emitting layer EML(R) with the 2-2th hole transport layer HTL2-2(R) interposed therebetween. Accordingly, the 2-2th hole transport layer HTL2-2(R) can function as a block layer blocking electron movement to the blue light emitting layer EML(B). Accordingly, although the blue light emitting layer EML(B) is extended in the red light emitting area R-EA, electron movement to the blue light emitting layer EML(B) can be blocked by the 2-2th hole transport layer HTL2-2(R), and thus light emission may not occur in the blue light emitting layer EML(B). As a result, a color of red light emitted from the red light emitting layer EML(R) of the red sub-pixel (R sub-pixel) does not change.

Separately, even if electrons move to the blue light emitting layer EML(B), the blue light emitting layer EML(B) can emit light in the red light emitting area R-EA. However, as shown in FIGS. 1A and 1B described above, since the OC spectrum of the red wavelength band does not overlap the PL spectrum of the blue wavelength band in the blue light emitting layer EML(B), the light emitted from the blue light emitting layer EML(B) is not emitted to the red light emitting area R-EA due to a destructive interference. As a result, a color of the red light emitted from the red light emitting layer EML(R) of the red sub-pixel (R sub-pixel) does not change.

In addition, in the blue light emitting area B-EA, the red light emitting layer EML(R) is in contact with the blue light emitting layer EML(B) and is disposed on the blue light emitting layer EML(B). Accordingly, there is no block layer blocking electron movement to the red light emitting layer EML(R), and the red light emitting layer EML(R) can emit light in the blue light emitting area B-EA. However, as shown in FIGS. 3A and 3B described above, since the OC spectrum of the blue wavelength band does not overlap the PL spectrum of the red wavelength band in the red light emitting layer EML(R), the light emitted from the red light emitting layer EML(R) is not emitted to the blue light emitting area B-EA due to a destructive interference. As a result, a color of the blue light emitted from the blue light emitting layer EML(B) of the blue sub-pixel (B sub-pixel) does not change.

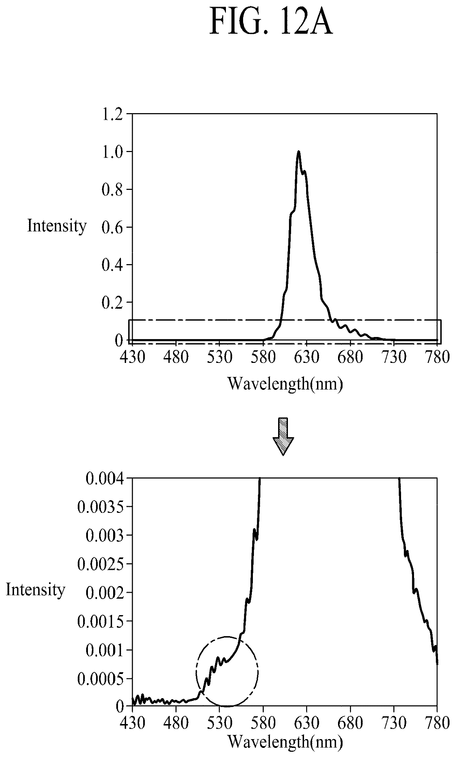

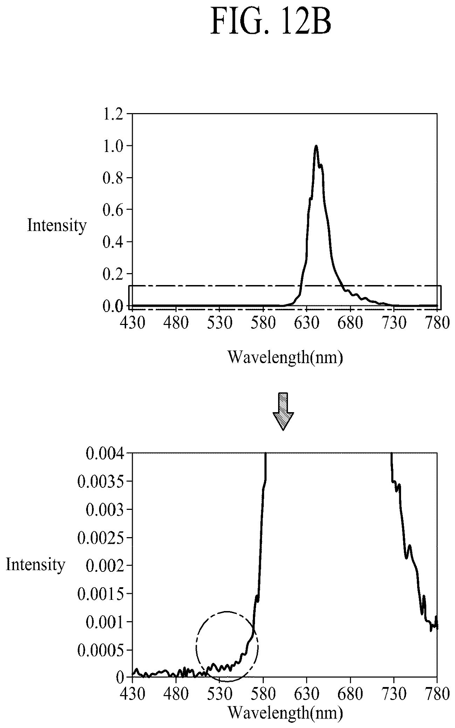

FIG. 12A is an EL spectrum of a red sub-pixel according to a comparative example, and FIG. 12B is an EL spectrum of a red sub-pixel according to an embodiment of the present disclosure.

Particularly, FIG. 12B relates to a structure of FIG. 5, and FIG. 12A relates to a structure in which the 2-2th hole transport layer HTL2-2(R) is removed between the green light emitting layer EML(G) and the red light emitting layer EML(R) in the red sub-pixel in the structure of FIG. 5 to contact the green light emitting layer EML(G) and the red light emitting layer EML(R) in the red sub-pixel.

As shown in FIG. 12A, when there is no 2-2th hole transport layer HTL2-2(R) between the green light emitting layer EML(G) and the red light emitting layer EML(R) in the red sub-pixel, the green light emitting layer EML(G) emits light together with the red light emitting layer EML(R), and light of a medium wavelength near 530 nm can be emitted. Accordingly, red light of a desired EL spectrum may not be emitted in the red sub-pixel.

On the contrary, as shown in FIG. 12B, when there is a 2-2th hole transport layer HTL2-2(R) between the green light emitting layer EML(G) and the red light emitting layer EML(R) in the red sub-pixel, electron movement to the green light emitting layer EML(G) is blocked by the 2-2th hole transport layer HTL2-2(R) and thus light emission may not occur in the green light emitting layer EML(G). Accordingly, red light of the desired EL spectrum according to light emission of the red light emitting layer EML(R) can be emitted from the red sub-pixel.

The following numbered examples pertain to embodiments of the present disclosure.

Example 1: An electroluminescent display device comprising: a substrate including a first sub-pixel and a second sub-pixel; a first electrode in each of the first sub-pixel and the second sub-pixel on the substrate; a light emitting part on the first electrode; and a second electrode on the light emitting part, wherein the light emitting part includes a hole transport layer, a first light emitting layer disposed in the first sub-pixel, a second light emitting layer disposed in the second sub-pixel, and an electron transport layer, wherein the second light emitting layer extends to the first sub-pixel and is disposed under the first light emitting layer, and wherein the hole transport layer is disposed between the second light emitting layer and the first light emitting layer in the first sub-pixel.

Example 2: The electroluminescent display device of Example 1, wherein the second light emitting layer extends to a light emitting area of the first sub-pixel, and wherein the hole transport layer is disposed between the second light emitting layer and the first light emitting layer in the light emitting area of the first sub-pixel.

Example 3: The electroluminescent display device of Example 1 or 2, wherein the first light emitting layer is configured to emit light having a longer wavelength than the second light emitting layer.

Example 4: The electroluminescent display device of any of Examples 1 to 3, wherein the hole transport layer includes: a first hole transport layer in the first sub-pixel and the second sub-pixel; and a second hole transport layer disposed on the first hole transport layer in the first sub-pixel, and wherein the second hole transport layer is disposed between the second light emitting layer and the first light emitting layer in the first sub-pixel.

Example 5: The electroluminescent display device of Example 4, wherein the first light emitting layer extends to the second sub-pixel.

Example 6: The electroluminescent display device of Example 4 or 5, wherein the first light emitting layer and the second hole transport layer are formed in a same pattern.

Example 7: The electroluminescent display device of Example 6, wherein the first light emitting layer and the second light emitting layer are spaced apart from each other with the second hole transport layer interposed therebetween and without contacting each other in the first sub-pixel and the second sub-pixel.

Example 8: The electroluminescent display device of Example 4 or 5, wherein the first light emitting layer and the second hole transport layer are formed in different patterns.

Example 9: The electroluminescent display device of Example 8, wherein the first light emitting layer and the second light emitting layer are spaced apart from each other with the second hole transport layer interposed therebetween and without contacting each other in the first sub-pixel, and contact each other in the second sub-pixel.

Example 10: The electroluminescent display device of any of Examples 4 to 9, wherein the hole transport layer further includes an additional hole transport layer disposed on the first hole transport layer in the second sub-pixel, and wherein the additional hole transport layer extends to the first sub-pixel and is disposed under the second light emitting layer.

Example 11: The electroluminescent display device of any of Examples 1 to 10, wherein a thickness of an extended portion of the second light emitting layer extending to the first sub-pixel is thinner than a thickness of the second light emitting layer disposed in the second sub-pixel.

Example 12: The electroluminescent display device of Example 5 or any of Examples 6 to 11 referring, directly or indirectly back to Example 5, wherein a thickness of an extended portion of the first light emitting layer extending to the second sub-pixel is thinner than a thickness of the first light emitting layer disposed in the first sub-pixel.

Example 13: The electroluminescent display device of Example 10 or any of Examples 11 to 12 referring, directly or indirectly back to Example 10, wherein a thickness of the additional hole transport layer in the first sub-pixel is thinner than that in the second sub-pixel.

Example 14: The electroluminescent display device of any of Example 4 or any of Examples 5 to 13 referring, directly or indirectly back to Example 4, wherein the second hole transport layer extends to the second sub-pixel, and a thickness of an extended portion of the second hole transport layer extending to the second sub-pixel is thinner than a thickness of the second hole transport layer disposed in the first sub-pixel.

Example 15: An electroluminescent display device comprising: a red sub-pixel including a red light emitting layer; a green sub-pixel including a green light emitting layer; a blue sub-pixel including a blue light emitting layer; a first hole transport layer disposed in the red sub-pixel, the green sub-pixel and the blue sub-pixel, and disposed under the red light emitting layer, the green light emitting layer, and the blue light emitting layer; a 2-1th hole transport layer disposed between the first hole transport layer and the green light emitting layer; and a 2-2th hole transport layer disposed between the first hole transport layer and the red light emitting layer, wherein the green light emitting layer extends to the red sub-pixel and is disposed under the red light emitting layer, and wherein the 2-2th hole transport layer is disposed between the green light emitting layer and the red light emitting layer.

Example 16: The electroluminescent display device of Example 15, wherein the green light emitting layer extends to a red light emitting area of the red sub-pixel and is disposed under the red light emitting layer, and wherein the 2-2th hole transport layer is disposed between the green light emitting layer and the red light emitting layer in the red light emitting area.

Example 17: The electroluminescent display device of Example 15 or 16, wherein the green light emitting layer and the red light emitting layer are spaced apart from each other with the 2-2th hole transport layer interposed therebetween and without contacting each other in the green sub-pixel and the red sub-pixel.

Example 18: The electroluminescent display device of Example 15 or 16, wherein the green light emitting layer and the red light emitting layer are spaced apart from each other with the 2-2th hole transport layer interposed therebetween and without contacting each other in the red sub-pixel, and contact each other in the green sub-pixel.

Example 19: The electroluminescent display device of any of Examples 15 to 18, wherein the 2-1th hole transport layer is in contact with the 2-2th hole transport layer in the red sub-pixel.

Example 20: The electroluminescent display device of any of Examples 15 to 18, wherein the 2-1th hole transport layer is not in contact with the 2-2th hole transport layer in the red sub-pixel and the green sub-pixel.

## Claims

1. An electroluminescent display device comprising:
a substrate (100) including a first sub-pixel (R Sub-pixel) and a second sub-pixel (G Sub-pixel);
a first electrode (400) in each of the first sub-pixel (R Sub-pixel) and the second sub-pixel (G Sub-pixel) on the substrate (100);
a light emitting part (500) on the first electrode (400); and
a second electrode (600) on the light emitting part (500),
wherein the light emitting part (500) includes a hole transport layer (HTL1, HTL2-2(R), HTL2-1(G)), a first light emitting layer (EML(R)) disposed in the first sub-pixel (R Sub-pixel), a second light emitting layer (EML(G)) disposed in the second sub-pixel (G Sub-pixel), and an electron transport layer (ETL),
wherein the second light emitting layer (EML(G)) extends to the first sub-pixel (R Sub-pixel) and is disposed under the first light emitting layer (EML(R)), and
wherein the hole transport layer (HTL1, HTL2-2(R) , HTL2-1(G)) is disposed between the second light emitting layer (EML(G)) and the first light emitting layer (EML(R)) in the first sub-pixel (R Sub-pixel).

2. The electroluminescent display device of claim 1, wherein the second light emitting layer (EML(G)) extends to a light emitting area (R-EA) of the first sub-pixel (R Sub-pixel), and
wherein the hole transport layer (HTL1, HTL2-2(R) , HTL2-1(G)) is disposed between the second light emitting layer (EML(G)) and the first light emitting layer (EML(R)) in the light emitting area (R-EA) of the first sub-pixel (R Sub-pixel).

3. The electroluminescent display device of claim 1 or 2, wherein the first light emitting layer (EML(R)) is configured to emit light having a longer wavelength than the second light emitting layer (EML(G)).

4. The electroluminescent display device of any of claims 1 to 3,
wherein the hole transport layer (HTL1, HTL2-2(R), HTL2-1(G)) includes:
a first hole transport layer (HTL1) in the first sub-pixel (R Sub-pixel) and the second sub-pixel (G Sub-pixel); and
a second hole transport layer (HTL2-2(R)) disposed on the first hole transport layer (HTL1) in the first sub-pixel (R Sub-pixel), and
wherein the second hole transport layer (HTL2-2(R)) is disposed between the second light emitting layer (EML(G)) and the first light emitting layer (EML(R)) in the first sub-pixel (R Sub-pixel).

5. The electroluminescent display device of claim 4, wherein the first light emitting layer (EML(R)) extends to the second sub-pixel (G Sub-pixel).

6. The electroluminescent display device of claim 4 or 5, wherein the first light emitting layer (EML(R)) and the second hole transport layer (HTL2-2(R)) are formed in a same pattern.

7. The electroluminescent display device of claim 6, wherein the first light emitting layer (EML(R)) and the second light emitting layer (EML(G)) are spaced apart from each other with the second hole transport layer (HTL2-2(R)) interposed therebetween and without contacting each other in the first sub-pixel (R Sub-pixel) and the second sub-pixel (G Sub-pixel).

8. The electroluminescent display device of claim 4, wherein the first light emitting layer (EML(R)) and the second hole transport layer (HTL2-2(R)) are formed in different patterns.

9. The electroluminescent display device of claim 8, wherein the first light emitting layer (EML(R)) and the second light emitting layer (EML(G)) are spaced apart from each other with the second hole transport layer (HTL2-2(R)) interposed therebetween and without contacting each other in the first sub-pixel (R Sub-pixel), and contact each other in the second sub-pixel (G Sub-pixel).

10. The electroluminescent display device of any of claims 4 to 9, wherein the hole transport layer (HTL1, HTL2-2(R), HTL2-1(G)) further includes an additional hole transport layer (HTL2-1(G)) disposed on the first hole transport layer (HTL1) in the second sub-pixel (G Sub-pixel), and
wherein the additional hole transport layer (HTL2-1(G)) extends to the first sub-pixel (R Sub-pixel) and is disposed under the second light emitting layer (EML(G)).

11. The electroluminescent display device of any of claims 1 to 10, wherein a thickness of an extended portion of the second light emitting layer (EML(G)) extending to the first sub-pixel (R Sub-pixel) is thinner than a thickness of the second light emitting layer (EML(G)) disposed in the second sub-pixel (G Sub-pixel).

12. The electroluminescent display device of claim 5 or any of claims 6 to 11 referring, directly or indirectly, back to claim 5, wherein a thickness of an extended portion of the first light emitting layer (EML(R)) extending to the second sub-pixel (G Sub-pixel) is thinner than a thickness of the first light emitting layer (EML(R)) disposed in the first sub-pixel (R Sub-pixel).

13. The electroluminescent display device of claim 10 or any of claims 11 to 12 referring, directly or indirectly, back to claim 10, wherein a thickness of the additional hole transport layer (HTL2-1(G)) in the first sub-pixel (R Sub-pixel) is thinner than that in the second sub-pixel (G Sub-pixel).

14. The electroluminescent display device of claim 4 or any of claims 5 to 13 referring, directly or indirectly, back to claim 4, wherein the second hole transport layer (HTL2-2(R)) extends to the second sub-pixel (G Sub-pixel), and a thickness of an extended portion of the second hole transport layer (HTL2-2(R)) extending to the second sub-pixel (G Sub-pixel) is thinner than a thickness of the second hole transport layer (HTL2-2(R)) disposed in the first sub-pixel (R Sub-pixel).

15. The electroluminescent display device of any of claims 1 to 14, wherein:
the first sub-pixel (R Sub-pixel) is a red sub-pixel and the first light emitting layer (EML(R)) is a red light emitting layer, and the second sub-pixel (G Sub-pixel) is a green sub-pixel and the second light emitting layer (EML(G)) is a green light emitting layer;
or wherein:
the first sub-pixel (G Sub-pixel) is a green sub-pixel and the first light emitting layer (EML(G)) is a green light emitting layer, and the second sub-pixel (B Sub-pixel) is a blue sub-pixel and the second light emitting layer (EML(B)) is a blue light emitting layer.
